Europäisches Patentamt

European Patent Office

Office européen des brevets

(19)

(11) Publication number: **0 132 307**
**A2**

(12)

# EUROPEAN PATENT APPLICATION

(21) Application number: **84304262.3**

(22) Date of filing: **25.06.84**

(51) Int. Cl.⁴: **H 03 G 3/34**

(30) Priority: **24.06.83 GB 8317200**

(43) Date of publication of application: **30.01.85**
**Bulletin 85/5**

(84) Designated Contracting States: **AT BE CH DE FR GB IT**
**LI LU NL SE**

(71) Applicant: **MOTOROLA GmbH, Heinrich-Hertz-Strasse 1,**
**D-2604 Taunusstein (DE)**

(72) Inventor: **König, Matthias, Derrlochstrasse 23,**
**Wiesbaden (DE)**

(74) Representative: **Ibbotson, Harold, Motorola Ltd Patent**
**and Licensing Operations - Europe Jays Close Viables**
**Industrial Estate, Basingstoke Hampshire RG22 4PD**
**(GB)**

(54) **Receiver having a noise blanker.**

(57) A communications system receiver having a noise blanker comprising:

tuner means (4) for tuning the receiver to a desire band (2A) and for producing at its output an output signal representative of a signal received in the tuned band;

first band-pass filter means (12) having an input connected to the output of the tuner means and an output, the first band-pass filter means passing signals in a first predetermined band (2C) in the tuned band;

second band-pass filter means (16) having an input connected to the output of the tuner means and an output, the second band-pass filter means passing signals in a second band (2B) in the tuned band;

noise pulse detector means (20, 22) having an input connected to the output of the second band-pass filter means and an output;

blanker means (14) having a signal input connected to the output of the first band-pass filter means, an output and a control input connected to the output of the noise pulse detector means, the blanker means producing at its output signals received in the first predetermined band when no noise pulses are detected in the second band and the blanker means blanking its output when a noise pulse is detected in the second band.

RECEIVER HAVING A NOISE BLANKER

## Field of Invention

This invention relates to noise blanking. Noise blanking is a technique used in communications systems receivers, and particularly in radio receivers, where a noise detector is used to activate a blanking device so that a received signal is blanked-off from further signal processing when noise is present.

## Background of Invention

In a known receiver employing noise blanking, in addition to the receiver's main channel to which the receiver is tuned to receive information signals, the receiver also uses another channel (an "extender" channel) adjacent to the receiver's main channel for sensing the presence of broadband noise (such as that caused by motor vehicle ignition systems) which will appear on both the main channel and the extender channel.

Such a receiver suffers from the disadvantage that it is wasteful in its use of the available frequency spectrum (it uses only one channel to receive information signals, but occupies two channels of the available frequency spectrum).

Also, such a receiver suffers from the disadvantage that because two different channels are used there is considerable duplication of circuitry for the two channels : in practice the whole of the receiver "front-end" is duplicated.

Also, such a receiver suffers from the disadvantage that although the extender channel is tuned to a particular channel during assembly of the receiver, it is often found that when the receiver is used in its normal operating environment interference (e.g. another operator) is present on the extender channel. When this happens the extender channel must be re-tuned, in the field, to an unused channel : this re-tuning procedure is inconvenient and may be expensive.

It is an object of the present invention to provide a communications system receiver having a noise blanker wherein the above disadvantages may be overcome or at least alleviated.

0132307

## Brief Summary of the Invention

In accordance with the invention a communications system receiver having a noise blanker comprises tuner means for tuning the receiver to a desired band and for producing at its output an output signal representative of a signal received in the tuned band;

first band-pass filter means having an input connected to the output of the tuner means and an output, the first band-pass filter means passing signals in a first predetermined band in the tuned band;

second band-pass filter means having an input connected to the output of the tuner means and an output, the second band-pass filter means passing signals in a second band in the tuned band;

noise pulse detector means having an input connected to the output of the second band-pass filter means and an output;

blanker means having a signal input connected to the ouput of the first band-pass filter means, an output and a control input connected to the output of the noise pulse detector means, the blanker means producing at its output signals received in the first predetermined band when no noise pulses are detected in the second band and the blanker means blanking its output when a noise pulse is detected in the second band.

A communications system radio receiver in accordance with the invention will now be described, by way of example only, with reference to the accompanying drawings, in which:

Figure 1 shows a block-schematic diagram of part of the circuit of the radio receiver;

Figure 2 shows the pass-bands of various filters in the receiver of Figure 1;

Figure 3 shows graphically the frequency range used by the receiver of Figure 1 compared with a conventional receiver; and

Figure 4 shows a modification of part of the receiver of Figure 1.

0132307

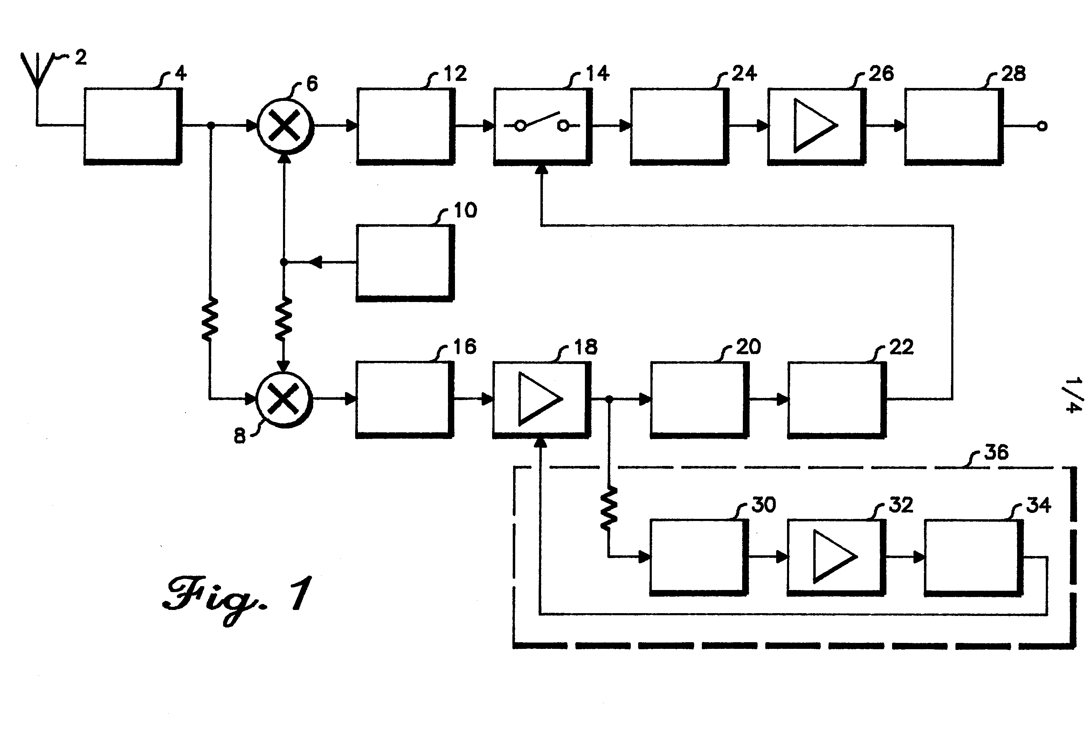

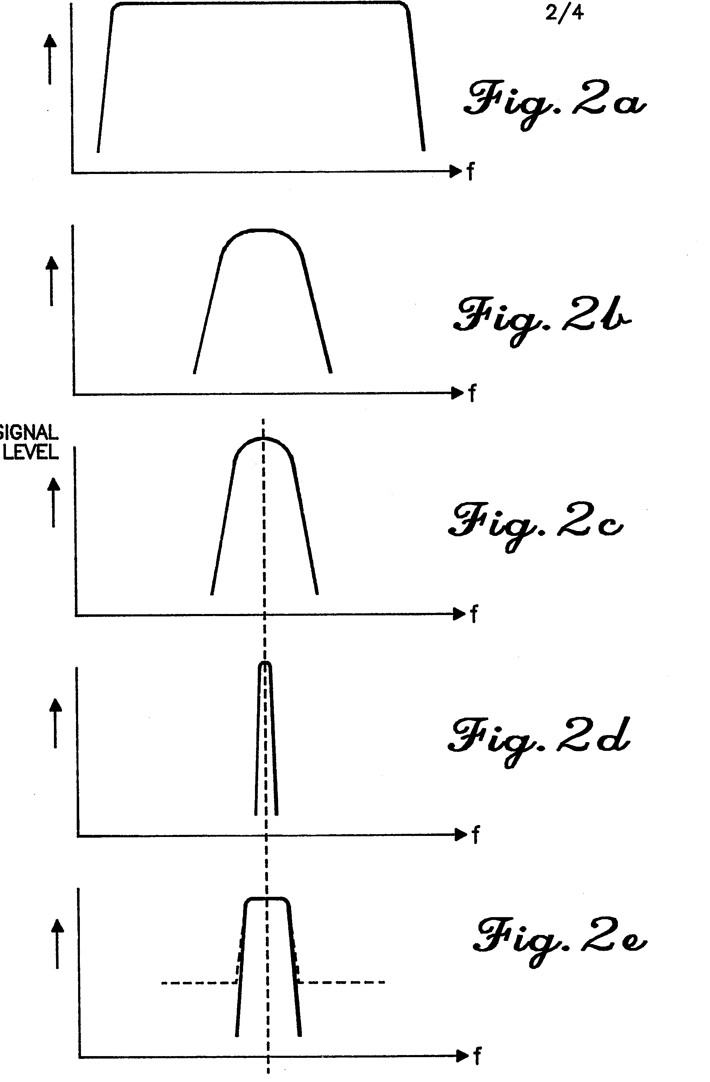

Referring firstly to Figure 1, a radio receiver, of which only the high-frequency part is shown, includes an antenna 2. The antenna is connected to the input of a "front-end" tuner which forms a preselector 4. The preselector output is connected to first inputs of two mixers 6, 8. A local oscillator 10 is connected to the second inputs of the two mixers 6, 8. The output of mixer 6 is connected through a first band-pass filter 12, to a blanker 14.

The output of mixer 8 is connected through a second band-pass filter 16 to the signal input of a variable gain amplifier 18. The output of the amplifier 18 is connected to the input of a pulse detector 20. The output of the pulse detector 20 is connected to a pulse-shaping amplifier 22, and the output of the amplifier 22 is connected to a control input of the blanker 14.

The output of the blanker 14 is connected through an intermediate frequency, crystal, band-pass filter 24 and through an intermediate frequency amplifier 26 to a demodulator 28. The output from the demodulator 28 is connected to low frequency, audio circuitry (not shown).

All of the above components are known per se and will not be described in further detail.

The output from the variable-gain amplifier 18 is also connected through a band-pass filter 30 and amplifier 32 to the input of a level detector 34. The output of the level detector 34 is connected to a control input of the variable gain amplifier 18. As will be explained below, the variable gain amplifier 18, the band-pass filter 30, the amplifier 32 and the level detector 34 together form a "splatter" control circuit 36.

Referring now also to Figure 2, in use of the first receiver, signal received via the antenna 2 are passed by the preselector 4 only in the band to which the preselector is tuned. The pass-band of the preselector is shown in Figure 2A. The preselector output signal is mixed in the mixers 6 and 8 with a signal of fixed frequency from the oscillator 10 to produce two independent signals of intermediate frequency. The input impedance of mixer 8 is high compared to the input impedance of mixer 6 to prevent degradation in receiver performance. The intermediate frequency signals are applied to the first and second band-pass filters 12 and 16 respectively. The pass-bands of the first and second band-pass filters are shown in Figures 2C and 2B respectively.

The pulse detector 20 detects noise pulses in the amplified output signal of the second band-pass filter 16, and the output of the detector 20 is amplified and shaped in amplifier 22 and applied to the blanker 14. In this way the blanker is enabled, blanking the output signal from the first band-pass filter 12, whenever noise pulses are detected in the output from the second band-pass filter 16. It will be appreciated that the pass-band of the first band-pass filter 12 (2C) is narrower than that of the second band-pass filter 16 (2B) so as to provide a longer delay to allow the noise blanker sufficient time to act. With the blanker 14 disabled, the unblanked output signal from the first band-pass filter is passed through the narrow band (see Figure 2D), intermediate frequency, crystal filter 24 and the intermediate frequency amplifier 26 to the demodulator 28. The low frequency output signal from the demodulator 28 is applied to audio amplifying circuitry (not shown) and a suitable transducer such as a loudspeaker (also not shown). If desired, the demodulated output signal could instead be applied to data processing equipment (not shown) to process the information contained therein.

It will be understood that by using separate mixers 6,8 for the signal and noise pulse detection channels respectively, good isolation of the pulse detection channel from blanker switching action and from impedance characteristic effects of band-pass filter 12 is achieved. It will be appreciated that if inferior isolation can be tolerated, a single mixer may be used.

In order to prevent interference between the frequency spectrum of the blanking pulses and the carrier frequencies of other radio transmitters transmitting on channels adjacent the receiver's own channel (so called "splatter"), which could degrade the signal-to-noise ratio of the receiver by up to 50dB or more, the "splatter" control circuit 36 is incorporated.

The "splatter" control circuit 36 operates as follows:

The output signal from the variable-gain amplifier 18 is applied through the "splatter" band-pass filter 30 and amplifier 32 to the level detector 34. When the input signal to the level detector exceeds a predetermined level, the level detector produces an output signal which decreases the gain of the variable-gain amplifier 18, so that the linear automatic gain control loop is closed.

The pass-band of the filter 30 is shown in Figure 2E. The sensitivity of the detector 20 is effectively reduced in dependence on the frequency responses of the second band-pass filter 16 and the "splatter" band-pass filter 30. The combined frequency response of both these filters is narrower than that of the first band-pass filter 12 in order to minimise extender blocking, but is wide enough to prevent degradation of receiver sensitivity caused by splatter in conventional receivers.

The threshold and gain of the pulse detector 20 and the pulse shaping amplifier 22 are optimised in accordance with the gain and frequency response of the complete splatter control circuit 36 to prevent splatter, and also blanker switching action and interference blanking by R.F. carriers.

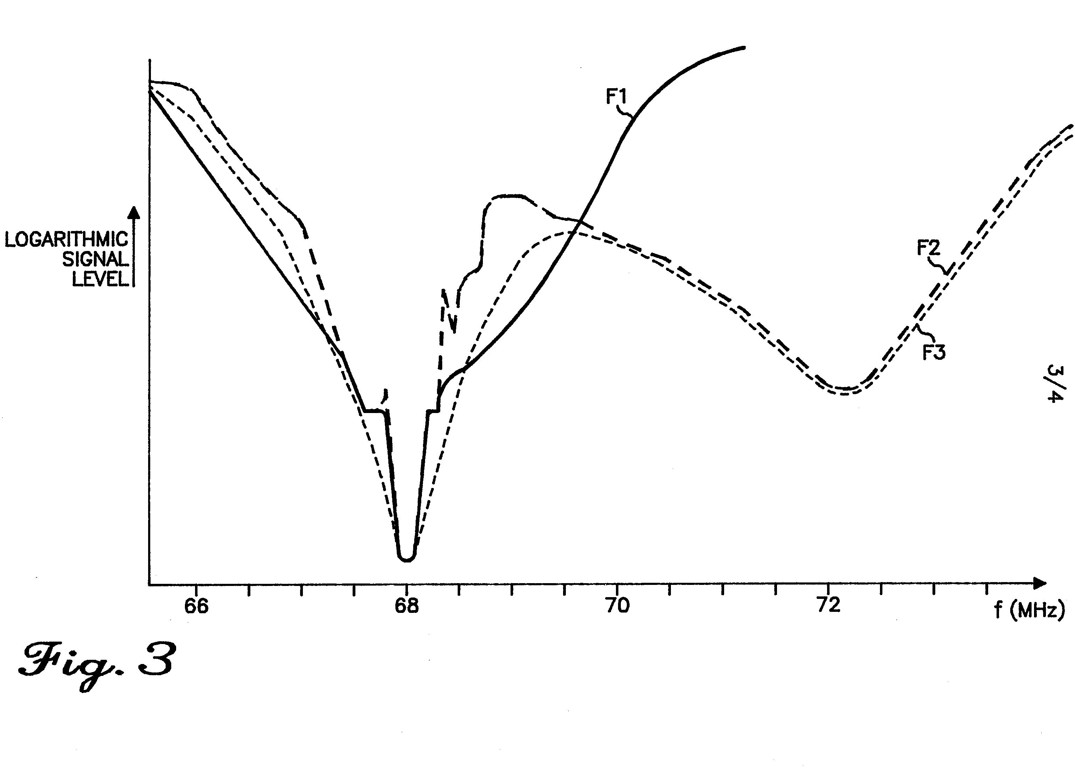

Figure 3 shows a comparison of the frequency response (F1) of the above described receiver (with splatter prevented) operating at a nominal frequency of 68 MHz with the frequency response (F2) of a conventional noise-blanking receiver in which splatter is not prevented, and with the frequency response (F3) of a conventional noise-blanking receiver in which splatter is prevented. As will be seen, the frequency range used by the receiver of this invention is approximately half that used by the conventional receiver.

It will be appreciated that the above described receiver saves space and costs and requires less tuning, compared with a conventional receiver, because a single preselector ("front-end") is used in both the main receiver part and the noise blanker part and because simple, fixed filters may be used for the second band-pass filter 16 and the "splatter" band-pass filter 30. Also the above described receiver achieves high noise pulse rate blanking using a minimum portion of the frequency spectrum and prevents splatter and interference blanking fully automatically with a minimum of unwanted extender blocking.

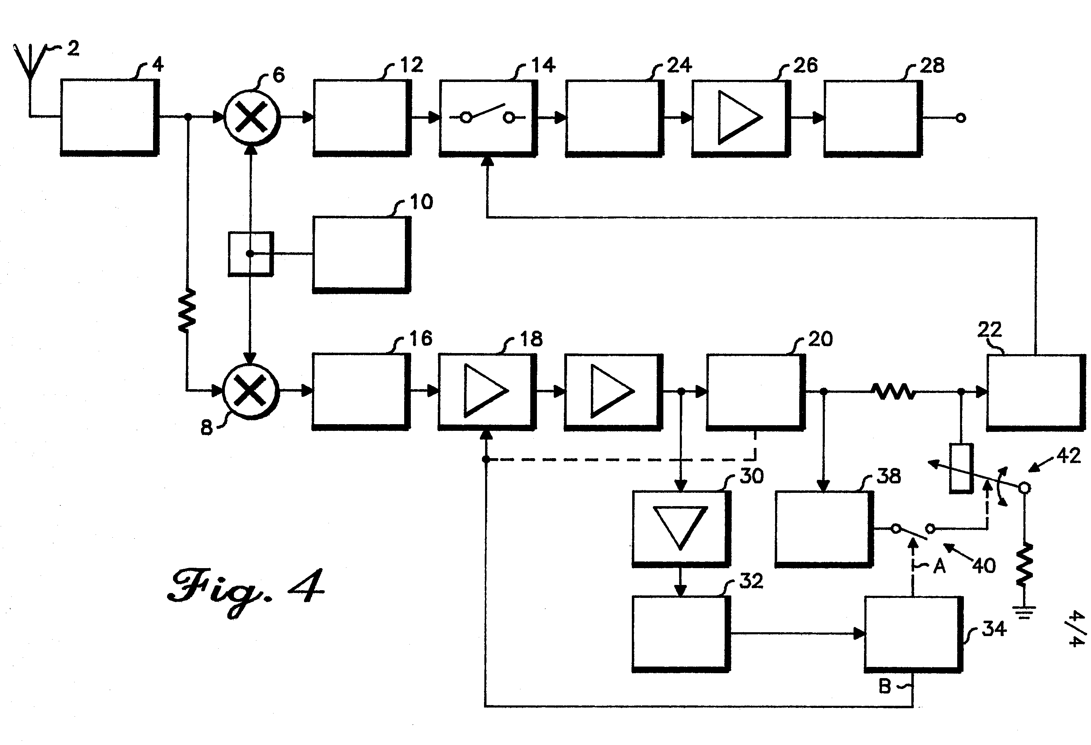

Figure 4 shows a modification of the circuit of Figure 1. In the circuit of Figure 4 the same components are used as in the circuit of Figure 1 (and for these the same reference numerals are used), but in addition a monostable and integrator 38 is provided with its input connected to the output of the detector 20. An electronic switch 40 is provided with its signal input connected to the output of the monostable and intergrator 38, and a variable voltage divider 42 is provided with one end connected to the input of the pulse shaping amplifier 22 and another end connected to ground. The control input of the voltage divider 42 is connected to the output of the switch 40 and the control input of the switch 40 is connected to an output of the level detector 34.

The modified circuit of Figure 4 operates basically in the same manner as the circuit of Figure 1, but the monostable and integrator 38 integrates the number of noise pulses detected by the detector 20 and produces an output voltage which is determined by the integrated number of noise pulses detected. When the level detector 34 responds at its output B, the "switch" 40 is effectively closed and the output voltage of the monostable and integrator 38 controls the variable voltage divider 42 to reduce the level of the input signal to the pulse-shaping amplifier 22 if the pulse rate increases. This is necessary, to prevent splatter also at high pulse rates, because the loop gain of the splatter control circuit is less than in the circuit of Figure 1 as a result of lower gain of the level detector 34 at its output A. In this way extender blocking is reduced at low pulse rates in comparison with the circuit of Figure 1.

If it is desired, or found necessary, further to modify the performance of the noise blanker circuit 36, this may be done by adjusting the gain of the amplifier 18 additionally in dependence on the output of the detector 20 to expand the dynamic range of the detector 20 around the pass-band of the "splatter" filter 30. This is shown by a dotted line connection in Figure 4. This expansion can also be achieved by limiting the selectivity of the "splatter" filter 30 (as shown in dotted line in Figure 2E). In this way the loop gain of the automatic gain control circuit around the pass-band of the "splatter" filter 30 can be optimised so that interference blanking of RF carriers can be prevented within the complete pass-band of filter 16. The selectivity limitation of filter 30 may also be used in the circuit of Figure 1.

CLAIMS

1. A communications system receiver having a noise blanker comprising:

tuner means for tuning the receiver to a desired band and for producing at its output an output signal representative of a signal received in the tuned band;

first band-pass filter means having an input connected to the output of the tuner means and an output, the first band-pass filter means passing signals in a first predetermined band in the tuned band;

second band-pass filter means having an input connected to the output of the tuner means and an output, the second band-pass filter means passing signals in a second band in the tuned band;

noise pulse detector means having an input connected to the output of the second band-pass filter means and an output;

blanker means having a signal input connected to the output of the first band-pass filter means, an output and a control input connected to the output of the noise pulse detector means, the blanker means producing at its output signals received in the first predetermined band when no noise pulses are detected in the second band and the blanker means blanking its output when a noise pulse is detected in the second band.

2. A receiver according to claim 1 wherein the second band is a predetermined band wider than and including the first predetermined band.

3. A receiver according to claim 1 or 2 further comprising mixer means connected between the output of the tuner means and the inputs of the first band-pass filter means and the second band-pass filter means for mixing the tuner means output signal with a locally produced signal.

0132307

4. A receiver according to claim 3 wherein the mixer means comprises: a first mixer having a first input connected to the output of the tuner means, a second input and an output connected to the input of the first band-pass filter means; a second mixer having a first input connected to the output of the tuner means, a second input and an output connected to the input of the second band-pass filter means; and a local signal generator having an output connected to the second inputs of the first and second mixers.

5. A receiver according to any preceding claim including splatter control means comprising:

variable amplifier means in the signal path between the output of the second band-pass means and the input of the noise pulse detector means;

third band-pass means having an input connected to the input of the noise pulse detector means and an output, the third band-pass means passing signals in a band centred on the same frequency as the first predetermined band; and

level detector means having an input connected to the output of the third band-pass means and an output, the level detector means producing a signal at its output to reduce the gain of the amplifier means when the third band-pass means passes a signal above a predetermined level.

6. A receiver according to claim 5 wherein the gain of the amplifier means is also controlled in dependence on the noise pulses detected by the noise pulse detector means.

7. A receiver according to claim 5 or 6 further comprising means for modifying the signals applied to the control input of the blanker means in dependence on the noise pulses detected by the noise pulse detector means.

Fig. 1

*Fig. 2a*

*Fig. 2b*

SIGNAL
LEVEL

*Fig. 2c*

*Fig. 2d*

*Fig. 2e*

*Fig. 3*

*Fig. 4*